**Europäisches Patentamt**

**European Patent Office**

**Office européen des brevets**

(19)

(11) **EP 0 851 573 B1**

(12) **FASCICULE DE BREVET EUROPEEN**

(45) Date de publication et mention
de la délivrance du brevet:
**20.02.2002 Bulletin 2002/08**

(51) Int Cl.⁷: **H03D 3/00**

(21) Numéro de dépôt: **97403134.6**

(22) Date de dépôt: **23.12.1997**

(54) **Dispositif d'estimation de l'écart de fréquence existant entre la fréquence porteuse d'un signal numérique et la fréquence d'un oscillateur local de réception, et récepteur correspondant**

Schaltung zur Schätzung der Frequenzverschiebung zwischen der Trägerfrequenz eines digitalen Signals und der Frequenz eines Überlagerungsoszillators und zugehöriger Empfänger

Device for estimating the frequency offset between a frequency carrier of a digital signal and the frequency of a local oscillator of a receiver, and corresponding receiver

(84) Etats contractants désignés:
**DE ES FI GB IT SE**

(30) Priorité: **30.12.1996 FR 9616195**

(43) Date de publication de la demande:
**01.07.1998 Bulletin 1998/27**

(73) Titulaire: **ALCATEL**
**75008 Paris (FR)**

(72) Inventeurs:
• **Guillemain, Christian**
**95110, Sannois (FR)**

• **Ferrad, Abdelkrim**
**93300 Aubervilliers (FR)**

(74) Mandataire: **Scheer, Luc et al**
**COMPAGNIE FINANCIERE ALCATEL Dépt.**
**Propr. Industrielle, 30, avenue Kléber**
**75116 Paris (FR)**

(56) Documents cités:
**GB-A- 2 211 703         US-A- 5 077 531**
**US-A- 5 103 431**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

**Description**

Le domaine de l'invention est celui de la transmission de signaux numériques et concerne plus précisément un dispositif destiné à estimer l'écart de fréquence existant entre la fréquence porteuse d'un signal numérique reçu par un récepteur et la fréquence du signal de sortie d'un oscillateur local compris dans ce récepteur et servant à la démodulation du signal reçu ou tout du moins à sa transposition en fréquence intermédiaire.

L'invention s'applique notamment à la transmission de signaux par satellite où notamment l'effet Doppler, les dérives du satellite et l'instabilité des équipements de transposition de fréquence introduisent des décalages en fréquence du signal reçu. Au niveau d'une station au sol recevant le signal du satellite, on observe après transposition en bande de base du signal reçu une rotation de la constellation, ce qui ne permet pas d'échantillonner le signal reçu aux instants où le diagramme de l'oeil est le plus ouvert.

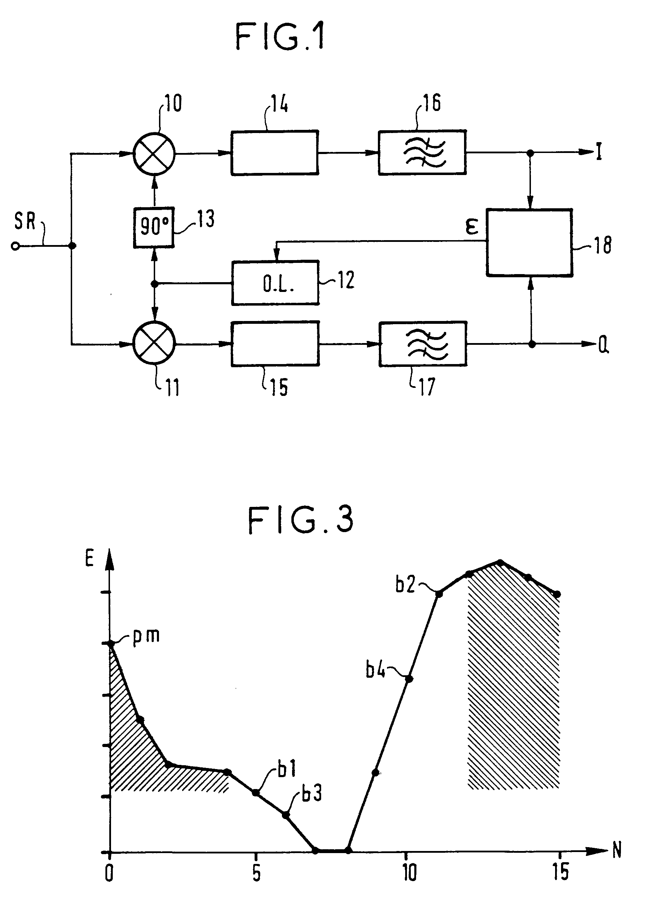

La figure 1 est un schéma synoptique d'un récepteur de signaux numériques comprenant un estimateur de l'écart de fréquence existant entre la fréquence porteuse d'un signal numérique reçu et la fréquence d'un oscillateur local de réception.

Le récepteur de la figure 1 comporte un démodulateur en quadrature à conversion directe auquel est appliqué le signal reçu, noté SR. Plus précisément, le signal SR est appliqué à deux mélangeurs 10, 11 recevant par ailleurs deux signaux de démodulation d'un oscillateur local 12, l'un (10) par l'intermédiaire d'un déphaseur de 90° référencé 13. Les mélangeurs 10 et 11 fournissent des signaux en bande de base à deux convertisseurs analogiques-numériques (CAN) 14, 15 suivis de filtres réception 16, 17, classiquement des filtres passe-bande en racine de Nyquist (filtres de Nyquist complexes). Les filtres 16 et 17 assurent une réjection des canaux adjacents en dehors de la bande du signal modulé SR et fournissent des trains I et Q qui représentent respectivement les composantes en phase et en quadrature du signal modulé SR. Chaque symbole reçu est codé sur K échantillons (K est par exemple égal à 4). Les trains I et Q sont appliqués à un estimateur 18 destiné à déterminer l'écart de fréquence entre le signal SR et le signal de sortie de l'oscillateur local 12. Cet écart de fréquence est noté E et appliqué à l'oscillateur local 12 afin de réaliser un contrôle automatique de fréquence.

L'estimateur 18 fonctionne classiquement selon l'algorithme d'Alberty. L'inconvénient de cet algorithme est qu'il ne fonctionne pas pour des décalages de fréquence supérieurs à Ds/4, avec Ds le débit symbolique, en cas de présence de perturbateurs. Ces perturbateurs sont, en transmission par satellite, constitués par les canaux adjacents au canal démodulé. Dès lors qu'un de ces canaux adjacents entre à ±Ds/2 dans la bande des filtres réception, l'estimateur 18 s'accroche sur ce canal adjacent et l'écart de fréquence ne peut plus être mesuré. Il s'en suit une perte du signal attendu.

La présente invention a notamment pour objectif de remédier à ces inconvénients.

Plus précisément, un des objectifs de l'invention est de fournir un dispositif d'estimation de l'écart de fréquence existant entre la fréquence porteuse d'un signal numérique reçu et la fréquence d'un signal d'oscillateur local compris dans un récepteur de ce signal reçu, ce dispositif d'estimation de fréquence fonctionnant dans une bande plus importante que l'algorithme d'Alberty et étant moins sensible que cet algorithme à la présence de perturbateurs.

Cet objectif, ainsi que d'autres qui apparaîtront par la suite, est atteint grâce à un dispositif d'estimation de l'écart de fréquence existant entre la fréquence porteuse d'un signal numérique reçu et la fréquence d'un signal d'oscillateur local compris dans un récepteur du signal reçu, le récepteur assurant une démodulation en quadrature du signal reçu, le dispositif comprenant :

- des moyens de détection du niveau de bruit reçu dans la bande des filtres réception ;
- des moyens de calcul de transformées de Fourier discrètes sur le signal reçu transposé en bande de base ;
- des moyens d'accumulation des énergies détectées de part et d'autre de la fréquence centrale des filtres réception ;
- des moyens de soustraction du niveau de bruit auxdites bandes d'énergie ;
- des moyens de comparaison des énergies résultantes, les moyens de comparaison fournissant une estimation de l'écart de fréquence.

Un tel estimateur présente l'avantage de fonctionner pour des décalages de fréquences inférieurs à Ds/2 en l'absence de perturbateurs.

Avantageusement, les moyens de comparaison sont des moyens de calcul du rapport des énergies résultantes.

Le dispositif de l'invention comprend préférentiellement des moyens de détection d'un décalage de fréquence supérieur à Ds/4, avec Ds le débit symbolique.

Ces moyens de détection d'un décalage de fréquence supérieur à Ds/4 comparent avantageusement le niveau d'énergie du point milieu (pm) du spectre obtenu à l'aide des moyens de calcul aux niveaux d'énergie de deux points situés immédiatement en-deçà des niveaux d'énergie à -3 dB de ce spectre et ils provoquent un décalage de ±Ds/4 de la fréquence de l'oscillateur local lorsqu'un des deux niveaux d'énergie est supérieur au niveau d'énergie du point milieu.

L'invention concerne également un récepteur de signal numérique comportant un tel dispositif d'estimation.

D'autres caractéristiques et avantages de l'invention apparaîtront à la lecture de la description suivante d'un mode de réalisation préférentiel, donné à titre illustratif et non limitatif, et des dessins annexés dans lesquels :

- la figure 1 est un schéma synoptique d'un récepteur connu de signaux numériques, ce récepteur comprenant un estimateur de l'écart de fréquence existant entre la fréquence porteuse d'un signal numérique reçu et la fréquence d'un oscillateur local de réception ;
- la figure 2 est un schéma synoptique d'un estimateur d'un tel écart de fréquence, selon la présente invention ;
- la figure 3 représente un spectre sur N=16 points de FFT obtenu après un lissage sur L=1000 vecteurs de FFT consécutives réalisées sur le signal reçu ;
- la figure 4 montre la variation d'une estimation ε en fonction de l'écart de fréquence normalisé au temps symbole, soit $\Delta F*Ts$, en l'absence de perturbateurs, pour N=16 points et L=1000 ;
- la figure 5 montre la variation de cette estimation ε en fonction de $\Delta F*Ts$, en présence de perturbateurs constitués par deux canaux adjacents situés de part et d'autre à 13 dB au delà du niveau du canal démodulé.

La figure 1 a été décrite précédemment en référence à l'état de la technique.

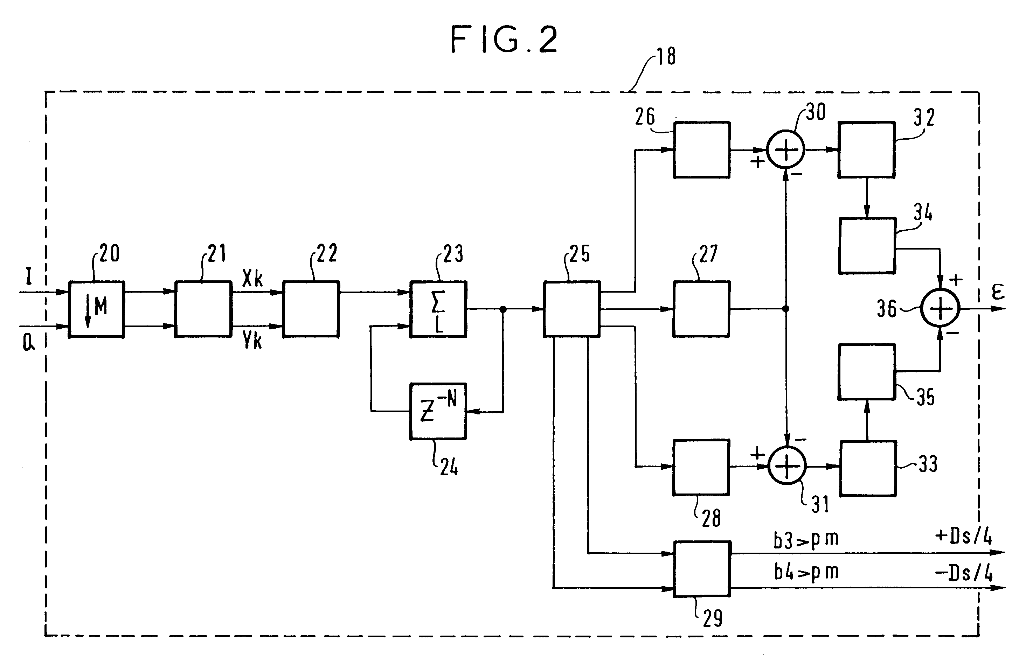

La figure 2 est un schéma synoptique d'un estimateur d'un écart de fréquence selon la présente invention.

Les trains I et Q en bande de base sont appliqués à un décimateur 20 facultatif, assurant une décimation éventuelle par un facteur M des bits reçus. L'utilisation de ce décimateur 20 est liée à une fonctionnalité de récepteur multi-débits. Au moins quatre échantillons par symbole sont disponibles à la sortie du décimateur 20. Les trains décimés sont appliqués à des moyens 21 de calcul de transformées de Fourier discrètes sur N points (FFT pour Fast Fourier Transform), fournissant des signaux $X_k$ et $Y_k$ représentatifs des amplitudes des points de FFT calculés. Ces signaux sont appliqués à une unité 22 de calcul du module au carré des amplitudes $X_k$ et $Y_k$. L'unité 22 fournit donc en sortie des vecteurs de valeur $X_k^2 + Y_k^2$. Chacun de ces vecteurs est constitué de N points de FFT. Un nombre L de vecteurs successifs sont accumulés dans un sommateur 23 coopérant avec une unité à décalage 24. Cette sommation a pour but de réaliser un lissage du spectre et d'atténuer ainsi la variance des N points de FFT pris séparément.

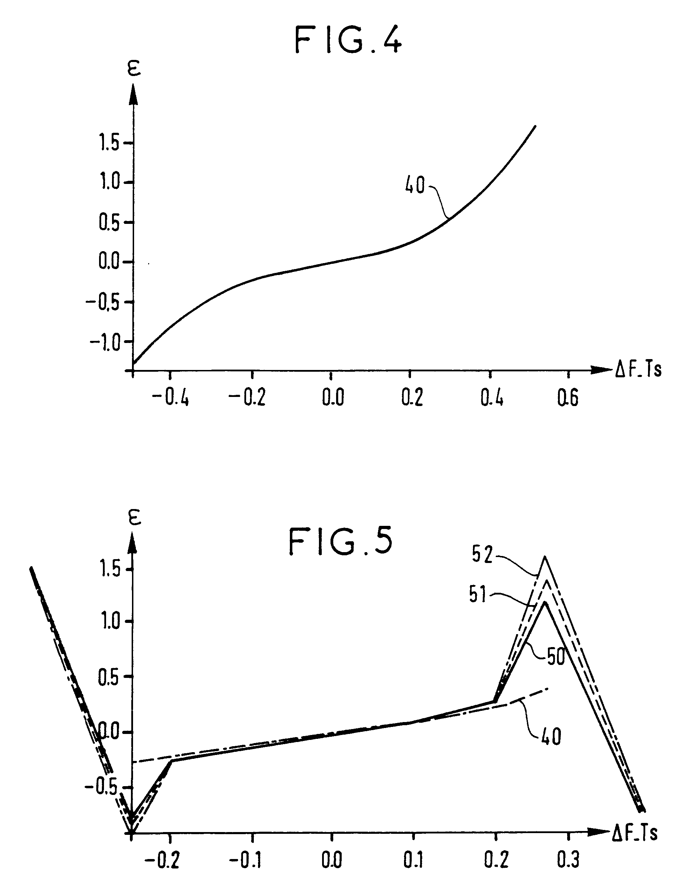

La figure 3 représente un spectre sur N=16 points de FFT obtenu après un lissage sur L=1000 vecteurs de FFT. Le rapport Eb/No est égal à 3 et le décalage en fréquence est égal à Ds/2 (cas le plus défavorable car la moitié de la bande d'un canal adjacent entre dans la bande du filtre réception). L'énergie détectée est notée E. On observe une dissymétrie du spectre due à cet écart de fréquence.

Afin d'estimer l'écart de fréquence précité, l'invention propose de comparer les énergies détectées de part et d'autre de la fréquence centrale des filtres réception 16 et 17 (FIG.1), après leur avoir soustrait le niveau de bruit présent dans le spectre reçu, comme il est décrit par la suite.

Les L vecteurs accumulés sont fournis à un démultiplexeur 25 assurant l'aiguillage des différents points du spectre vers quatre modules 26 à 29.

Le module 26 calcule l'énergie comprise dans la bande inférieure du spectre de la figure 3, par exemple celle comprise entre les points 0 et $b_1$-1, avec $b_1$ un point situé à une distance donnée du centre du spectre. Plus précisément, le module 26 calcule la valeur suivante :

$$\frac{1}{b_1} * \sum_{i=0}^{b1-1} E_i$$

avec $E_i$ les énergies des points compris entre 0 et $b_1$-1.

Réciproquement, le module 28 calcule l'énergie comprise dans la bande supérieure du spectre de la figure 3, par exemple celle comprise entre les points $b_2$+1 et N-1, avec $b_2$ un point situé à la même distance du centre du spectre que le point $b_1$. Plus précisément, le module 28 calcule la valeur suivante :

$$\frac{1}{N-b_2-1} * \sum_{i=b_2+1}^{N-1} E_i$$

avec $E_i$ les énergies des points compris entre $b_2$+1 et N-1.

Le module 27 calcule le minimum des points $b_1$ et $b_2$ afin de fournir une information sur le niveau de bruit. Sur la figure 3, ce niveau de bruit est donné par le point $b_1$, le point $b_2$ étant situé à un niveau d'énergie plus important. De manière générale, le bruit est estimé en comparant les points du spectre qui se situent à environ $\pm Ds/5$ de la fréquence centrale. Les points $b_1$ et $b_2$ peuvent être obtenus par les relations suivantes :

$$b_1 = \lceil (2.N.M/n.K) \rceil \text{ et } b_2 = N-b_1$$

La valeur de n dépend du roll-roff des filtres de Nyquist utilisés à la réception. Typiquement un tel roll-off est de l'ordre de 0,3 ou 0,4 et la valeur de n est de 5.

Des moyens de soustraction 30, 31 sont prévus pour soustraire le niveau de bruit donné par le module 27 aux niveaux d'énergie issus des modules 26 et 28. En sortie de ces moyens de soustraction 30, 31, on a donc respectivement les niveaux d'énergie résultants hachurés sur la figure 3. On s'affranchit ainsi du niveau de bruit variable récupéré dans la bande des filtres réception.

L'invention propose de comparer ensuite ces niveaux d'énergie résultants, leur différence étant proportionnelle à l'écart de fréquence à déterminer. A titre d'exemple, cette comparaison peut s'effectuer comme décrit ci-dessous :

Les énergies résultantes issues des moyens de soustraction 30, 31 sont appliquées à des circuits de valeur absolue 32, 33 suivis de convertisseurs logarithmiques 34, 35. Les sorties des circuits logarithmiques 34, 35 sont appliquées à un soustracteur 36 qui fournit l'estimation $\epsilon$.

L'estimation $\epsilon$ est ensuite fournie à une table de transcodage fournissant pour chaque estimation $\epsilon$ un décalage de fréquence à faire effectuer à l'oscillateur local 12 du récepteur (Fig.1). L'éventuel décalage de fréquence résiduel est ensuite corrigé à l'aide d'un autre algorithme permettant d'affiner la correction apportée.

La figure 4 montre la variation de l'estimation $\epsilon$ en fonction de l'écart de fréquence normalisé au temps symbole, soit $\Delta F^*Ts$, en l'absence de perturbateurs, pour N=16 points et L=1000.

On constate que cette caractéristique 40 est invariante en fonction du rapport Eb/No dans une plage comprise entre -0,5 et +0,5, cette plage correspondant à l'intervalle [-Ds/2, +Ds/2].

Le dispositif de l'invention décrit jusqu'ici fonctionne donc pour des décalages de fréquences compris entre $\pm Ds/2$, soit dans une plage deux fois plus importante que l'algorithme d'Alberty.

La figure 5 montre la variation de l'estimation $\epsilon$ en présence de deux canaux adjacents situés de part et d'autre à 13 dB au delà du niveau du canal démodulé (forts perturbateurs). A des fins de comparaison, la caractéristique 40 correspondant à celle de la figure 4 (absence de canaux adjacents) est également représentée. Les caractéristiques 50, 51 et 52 sont obtenues en présence des canaux adjacents précités, respectivement pour Eb/No égal à 3, 5 et 10. Toutes ces caractéristiques sont obtenues pour N=16 et L=1000.

On constate que quel que soit le niveau du perturbateur, l'estimation $\epsilon$ est fiable pour des décalages inférieurs à Ds/4 ($\Delta F^*Ts$ compris entre $\pm0,25$). En revanche, une très nette divergence (brutal changement de signe de la pente) de l'estimation $\epsilon$ est obtenue dès lors que l'écart de fréquence $\Delta F^*Ts$ sort de ces limites. Il s'en suit une ambiguïté sur la correction de fréquence à effectuer.

Afin de remédier à cet inconvénient, l'invention propose également de détecter que l'écart des fréquences normalisé au temps symbole $\Delta F^*Ts$ devient supérieur à Ds/4. A ce titre, le module 29 compare les niveaux d'énergie $b_3$ et $b_4$ de la figure 3 au point milieu pm du spectre reçu dans la bande considérée. Ce point milieu pm est celui obtenu pour la FFT de rang 0. Il est situé 3 dB en-deçà du niveau maximum pour un décalage de fréquences de Ds/2. Les points $b_3$ et $b_4$ sont typiquement situés à N/2 $\pm$ 2. En pratique, les points $b_3$ et $b_4$ sont les points du spectre correspondants à $\pm Ds/2$ et sont les premiers points du spectre situés en-deçà des niveaux d'énergie à -3 dB.

Le module 29 ordonne à l'oscillateur local du récepteur un décalage de +Ds/4 si le niveau d'énergie du point $b_3$ est supérieur au niveau d'énergie du point pm et un décalage de -Ds/4 si le niveau d'énergie du point $b_4$ est supérieur au niveau d'énergie du point pm. En effet, si l'un de ces deux points possède une énergie supérieure à pm, cela signifie qu'une partie de l'énergie d'un perturbateur adjacent est située dans la bande des filtres de Nyquist et que l'analyse est décalée d'une valeur supérieure ou égale à Ds/4. Ce décalage de $\pm Ds/4$ permet donc de recentrer le spectre dans la bande pour laquelle à une estimation $\epsilon$ ne correspond qu'un seul décalage de fréquence $\Delta F^*Ts$ à apporter (caractéristique univoque). Le module 29 constitue donc un moyen de détection d'un décalage de fréquence supérieur à Ds/4.

En fonction du décalage de fréquence existant entre la fréquence porteuse du signal reçu et la fréquence du signal d'oscillateur local, une ou plusieurs accumulations successives de L vecteurs peuvent donc devoir être réalisées :

- en l'absence de perturbateur ou pour un décalage inférieur à $\pm Ds/4$, la convergence est immédiatement obtenue après accumulation de L vecteurs ;
- en présence d'un décalage supérieur à $\pm Ds/4$ et en présence de perturbateurs, deux accumulations successives de L vecteurs sont nécessaires, une première pour repositionner le spectre par décalage de $\pm Ds/4$, une deuxième pour permettre l'obtention d'une estimation $\epsilon$ fiable.

Le dispositif d'estimation de l'invention est applicable aux systèmes de transmission opérant sur des modulations employant au moins 4 échantillons par symbole. Il se prête notamment à la réception de données transmises par satellite et à une implantation en ASIC.

**Revendications**

1. Dispositif d'estimation de l'écart de fréquence existant entre la fréquence porteuse d'un signal numérique reçu et la fréquence d'un signal d'oscillateur local compris dans un récepteur dudit signal reçu, ledit récepteur assurant une démodulation en quadrature dudit signal reçu, ledit dispositif comprenant :

- des moyens (27) de détection du niveau de bruit reçu dans la bande des filtres réception (16, 17) ;

- des moyens (21) de calcul de transformées de Fourier discrètes sur le signal reçu (SR) transposé en bande de base (I, Q) ;
- des moyens (23) d'accumulation des énergies détectées de part et d'autre de la fréquence centrale desdits filtres réception (16, 17) ;
- des moyens (30, 31) de soustraction dudit niveau de bruit auxdites bandes d'énergie ;
- des moyens (32 à 36) de comparaison des énergies résultantes, lesdits moyens (32 à 36) de comparaison fournissant une estimation ($\varepsilon$) dudit écart de fréquence.

**2.** Dispositif selon la revendication 1, **caractérisé en ce que** lesdits moyens de comparaison (32 à 36) sont des moyens de calcul du rapport des énergies résultantes.

**3.** Dispositif selon l'une des revendications 1 et 2, **caractérisé en ce qu'**il comprend en outre des moyens (29) de détection d'un décalage de fréquence supérieur à Ds/4, avec Ds le débit symbolique.

**4.** Dispositif selon la revendication 3, **caractérisé en ce que** lesdits moyens (29) de détection d'un décalage de fréquence supérieur à Ds/4 comparent le niveau d'énergie du point milieu (pm) du spectre obtenu à l'aide desdits moyens de calcul (21) aux niveaux d'énergie de deux points ($b_3$, $b_4$) situés immédiatement en-deçà des niveaux d'énergie à -3 dB dudit et **en ce qu'**ils provoquent un décalage de $\pm$Ds/4 de la fréquence dudit oscillateur local (12) lorsqu'un desdits deux niveaux d'énergie ($b_3$, $b_4$) est supérieur audit niveau d'énergie dudit point milieu (pm).

**5.** Récepteur de signal numérique, **caractérisé en ce qu'**il comporte un dispositif selon l'une des revendications 1 à 4.

**Patentansprüche**

**1.** Vorrichtung zum Abschätzen der Frequenzabweichung, die zwischen der Trägerfrequenz eines empfangenen digitalen Signals und der Frequenz eines Signals eines lokalen Oszillators besteht, der in einem Empfänger des empfangenen Signals enthalten ist, wobei der Empfänger eine Quadratur-Demodulation des empfangenen Signals bewirkt, wobei die Vorrichtung umfasst:

- Mittel (27) zum Erfassen des im Band der Empfangsfilter (16, 17) empfangenen Rauschpegels;

- Mittel (21) zum Berechnen von diskreten Fouriertransformierten des ins Basisband (I, Q) verschobenen empfangenen Signals (SR) ;
- Mittel (23) zum Akkumulieren der erfassten Energien beiderseits der Mittenfrequenz der Empfangsfilter (16, 17) ;
- Mittel (30, 31) zum Subtrahieren des Rauschpegels von den Energiebändern;
- Mittel (32 bis 36) zum Vergleichen der resultierenden Energien, wobei diese Vergleichsmittel (32 bis 36) eine Abschätzung ($\varepsilon$) der Frequenzabweichung liefern.

**2.** Vorrichtung nach Anspruch 1, **dadurch gekennzeichnet, dass** die Mittel zum Vergleichen (32 bis 36) Mittel zum Berechnen des Verhältnisses der resultierenden Energien sind.

**3.** Vorrichtung nach einem der Ansprüche 1 und 2, **dadurch gekennzeichnet, dass** sie ferner Mittel (29) zum Erfassen einer Frequenzverschiebung von mehr als Ds/4 umfasst, wobei Ds die Symbolrate ist.

**4.** Vorrichtung nach Anspruch 3, **dadurch gekennzeichnet, dass** die Mittel (29) zum Erfassen einer Frequenzverschiebung von mehr als Ds/4 den Energiepegel des Mittenpunktes (pm) des mit Hilfe der Rechenmittel (21) erhaltenen Spektrums mit den Energiepegeln von zwei Punkten ($b_3$, $b_4$) vergleichen, die unmittelbar jenseits der Energieniveaus bei -3 dB des [Spektrums] liegen, und dass sie eine Verschiebung der Frequenz des lokalen Oszillators (12) um $\pm$ Ds/4 bewirken, wenn einer der zwei Energiepegel ($b_3$, $b_4$) höher als der Energiepegel des Mittenpunktes (pm) ist.

**5.** Empfänger für ein digitales Signal, **dadurch gekennzeichnet, dass** er eine Vorrichtung nach einem der Ansprüche 1 bis 4 umfasst.

**Claims**

**1.** Apparatus for estimating the frequency difference existing between the carrier frequency of a received digital signal and the frequency of a signal from a local oscillator contained in a receiver of said received signal, said receiver performing quadrature demodulation on said received signal, said apparatus comprising:

detector means (27) for detecting the noise level received in the receive filter bands (16, 17); computing means (21) for computing discrete Fourier transforms on the received signal (SR) transposed into baseband (I, Q); summing means (23) for summing the energy levels detected on either side of said receive filter center frequencies (16, 17);
subtractor means (30, 31) for subtracting said noise level from said energy bands; and comparator means (32 to 36) for comparing the resulting energy levels, said comparator means (32 to 36) delivering an estimate ($\varepsilon$) of said frequency difference.

2. Apparatus according to claim 1, **characterized in that** said comparator means (32 to 36) are means for computing the ratio of the resulting energy levels.

3. Apparatus according to claim 1 or 2, **characterized in that** it further includes means (29) for detecting a frequency shift greater than Ds/4, where Ds is the symbol rate.

4. Apparatus according to claim 3, **characterized in that** said means (29) for detecting a frequency shift greater than Ds/4 compare the energy level of the midpoint (pm) of the spectrum obtained by means of said computing means (21) with the energy levels of two points ($b_3$, $b_4$) situated immediately below the -3 dB energy levels of said spectrum, and **in that** they cause the frequency of said local oscillator (20) to be shifted by $\pm$Ds/4 when one of said two energy levels ($b_3$, $b_4$) is greater than said energy level of said midpoint (pm).

5. A digital signal receiver, **characterized in that** it includes apparatus according to any one of claims 1 to 4.

# FIG.1

# FIG.3

FIG.2

# FIG.4

# FIG.5